# EUROPEAN PATENT APPLICATION

(11) **EP 2 320 712 A1**
(43) Date of publication of application: **11.05.2011**
(21) Application number: 09802884.8
(22) Date of filing: 23.07.2009
(51) Int. Cl.: H05B 33/10, B41F 17/14, B41M 1/02, B41M 1/30, G09F 9/30, H01L 27/32, H01L 51/50, H05B 33/02, H05B 33/12, H05B 33/22

(54) **METHOD FOR MANUFACTURING AN ORGANIC ELECTROLUMINESCENCE ELEMENT, LIGHT EMITTING DEVICE, AND DISPLAY DEVICE**

(30) Priority: 30.07.2008 JP 2008195965
(71) Applicant: Sumitomo Chemical Company, Limited, Tokyo 104-8260 (JP)
(72) Inventor: ROKUHARA, Kouichi, Shimotsuma-shi Ibaraki 304-0823 (JP); MATSUMURO, Tomonori, Tsukuba-shi Ibaraki 305-0051 (JP)
(74) Representative: Duckworth, Timothy John
(86) International application number: PCT/JP2009/063214
(87) International publication number: WO 2010/013641

(57) **Abstract**

The present invention provides a method of manufacturing an organic EL element using a relief printing method that can prevent color mixing caused during ink supply, a light-emitting device with which color mixing can be prevented, and a display device comprising the light-emitting device. Specifically, provided is, for example, a method of manufacturing an organic electroluminescent element that comprises a pair of electrodes and an organic layer located between the electrodes, the method comprising: providing a substrate on which a plurality of partition walls are arranged in substantially parallel to each other, and in which a groove portion is formed on a face of each of the partition walls along a longitudinal direction of the partition walls, the face opposing another face near the substrate; and forming the organic layer by supplying an ink containing a material for the organic layer to concave portions formed with the partition walls and the substrate, using a relief printing plate in which a plurality of convex portions are arranged in substantially parallel to each other so as to correspond to the concave portions.

## Description

### TECHNICAL FIELD

The present invention relates to a manufacturing method of an organic electroluminescent element, a light-emitting device, and a display device.

### BACKGROUND ART

An organic electroluminescent element (hereinafter, also referred to as an "organic EL element") comprises a pair of electrodes and a light-emitting layer (an organic layer) located between the electrodes, and emits light by making holes and electrons that are injected from each of the pair of electrodes couple in the light-emitting layer.

In a display panel used in a display device, a number of organic EL elements are arranged in a matrix on a substrate. Each of the organic EL elements functions as a portion of pixels. Typically, in such a display panel, partition walls are arranged in a grid, and the organic layer of each organic EL element is formed in each pixel area defined by the partition walls.

The organic layer can be formed into a film by an application method using an ink containing a material for the organic layer and a solvent. Specifically, the organic layer is formed into a film by selectively supplying the ink into each pixel area, and then drying and removing the solvent of the ink. For example, known is a method for forming an organic layer by selectively supplying an ink into each pixel area by a relief printing method using a relief printing plate comprising convex portions patterned corresponding to the arrangement of each pixel area and then drying the ink (see, e.g., Patent Document 1).

### PRIOR ART DOCUMENTS

### PATENT DOCUMENTS

Patent Document 1: Japanese Patent Application Laid-open No. 2006-286243

### SUMARRY OF INVENTION

### PROBLEM TO BE SOLVED BY THE INVENTION

The material for an organic layer has poor solubility, and thus, the ratio of the material for the organic layer in the ink is typically about 1% by weight, and the ink mostly comprises a solvent. The solvent is a component to be removed during drying after the ink is supplied. When a film of the organic layer is formed using such ink, a large amount of ink relative to the volume of the organic layer needs to be supplied to the inside of the partition walls for forming an organic layer having a certain thickness of the film, and thus, an ink having an amount larger than the volume of the inside of the partition walls is typically supplied. As a result, the ink supplied to the inside of certain partition walls may overflow the inside of the partition walls into the inside of the neighboring partition walls. For example, in a color display panel, three kinds of ink containing materials emitting light in each color of RGB are selectively supplied to the inside of certain partition walls to form light-emitting layers in each color. When such different kinds of ink supplied to the inside of certain partition walls flow into the inside of the neighboring partition walls, a problem of color mixing in which different kinds of ink are mixed occur.

Accordingly, an object of the present invention is to provide a method of manufacturing an organic EL element using a relief printing method that can prevent color mixing caused during ink supply, and a light-emitting device having a structure with which color mixing is easily prevented, and a display device comprising the light-emitting device.

### MEANS FOR SOLVING PROBLEM

The present invention is a method for manufacturing an organic electroluminescent element that comprises a pair of electrodes and an organic layer located between the electrodes, the method comprising:
providing a substrate on which a plurality of partition walls are arranged in substantially parallel to each other, and in which a groove portion is formed on a face of each of the partition walls along a longitudinal direction of the partition walls, the face opposing another face near the substrate; and
forming the organic layer by supplying an ink containing a material for the organic layer to concave portions formed with the partition walls and the substrate, using a relief printing plate in which a plurality of convex portions are arranged in substantially parallel to each other so as to correspond to the concave portions.

The present invention is also a method for manufacturing an organic electroluminescent element, wherein the groove portion is formed to pass through the partition walls.

The present invention is also a device for manufacturing an organic electroluminescent element, wherein a width of the groove portion in a direction perpendicular to a thickness direction of the substrate and the longitudinal direction is 5 micrometers to 30 micrometers.

The present invention is also a method for manufacturing an organic electroluminescent element, wherein a height of the partition wall is 0.1 or more micrometer.

The present invention is also a light-emitting device comprising:
a substrate;
a plurality of partition walls mounted on the substrate which are substantially parallel to each other; and
an organic electroluminescent element that comprises a pair of electrodes provided on the substrate and an organic layer located between the electrodes;
   wherein the organic layer is formed between the partition walls, and
   wherein a groove portion is formed on a face of each of the partition walls along a longitudinal direction of the partition walls, the face opposing another face near the substrate.

The present invention is also a display device comprising the light-emitting device.

### EFFECT OF THE INVENTION

According to the present invention, the groove portion is formed on the face of the partition walls along the longitudinal direction of the partition walls, the face opposing another face near the substrate. With this structure, even when the ink supplied to a portion between the partition walls overflows the portion, the overflowed ink flows into the groove portion formed in the partition walls. Therefore, the ink can be prevented from flowing into a portion between the neighboring partition walls, and thus, color mixing can be prevented.

Moreover, alignment between the relief printing plate and the substrate does not need to be performed in high-precision as in conventional arts because color mixing can be avoided by providing the groove portion, and thus, the ink can be supplied efficiently.

According to the present invention, color mixing is prevented because the groove portion is formed on the face of the partition walls along the longitudinal direction of the partition walls, the face opposing another face near the substrate. Therefore, a light-emitting device that can be efficiently manufactured by a relief printing method can be realized.

### BRIEF DESCRIPTION OF DRAWINGS

[Fig. 1] Fig. 1 is a plane schematic of a substrate used in a display device of an embodiment of the present invention.
[Fig. 2] Fig. 2 is a sectional schematic of the substrate viewed from a sectional line II-II of Fig. 1.
[Fig. 3] Fig. 3 is a schematic illustrating a process of forming a film of a hole injection layer or a hole transport layer from a solution.

### BEST MODE(S) FOR CARRYING OUT THE INVENTION

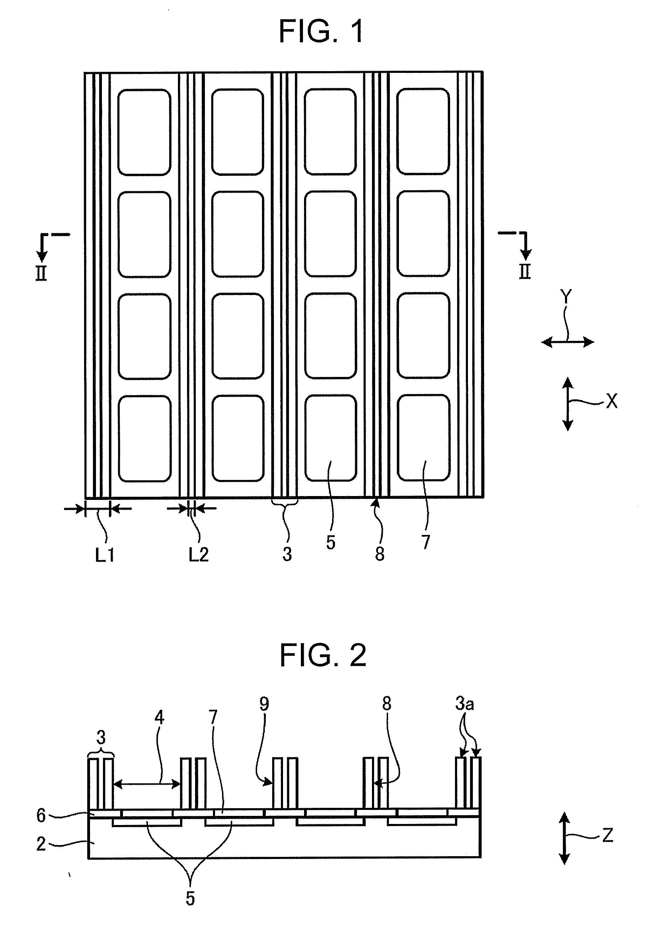

Fig. 1 is a plane schematic of a substrate that is used in a light-emitting device of an embodiment of the present invention and to which several members are provided. Fig. 2 is a sectional schematic of the substrate viewed from a sectional line II-II of Fig. 1. The light-emitting device comprises a substrate 2, a plurality of partition walls 3 arranged on the substrate 2 which are substantially parallel to each other, and an organic electroluminescent element that comprises a pair of electrodes provided on the substrate 2 and an organic layer located between the electrodes. The organic layer is formed at a portion 4 between partition walls, and a groove portion 8 is formed in a face 3a of each of the partition walls 3 along the longitudinal direction of the partition wall 3, the face opposing another face near the substrate 2. Fig. 1 and Fig. 2 illustrate states before the organic layer is provided.

Hereinafter, a passive matrix light-emitting device is described. In the present embodiment, a plurality of electrodes 5 (one of a pair of electrodes, and hereinafter, abbreviated as the electrodes 5 as needed) which are arrayed in substantially parallel to each other are provided on the substrate 2. Hereinafter, the longitudinal direction of the electrodes 5 may be called a line direction X, the thickness direction of the substrate 2 may be called a thickness direction Z, and a direction perpendicular to the line direction X and the thickness direction Z may be called an array direction Y. The electrodes 5 in the present embodiment are arrayed to be spaced uniformly in the line direction X.

In the light-emitting device of the present embodiment, an insulating film 6 covering the substrate 2 and the electrodes 5 from one side of the thickness direction Z is further provided. A plurality of through-holes 7 that pass through the insulating film 6 in the thickness direction Z is formed in the insulating film 6 on each of the electrodes 5. Each of the through-holes 7 is formed on each electrode 5 at certain intervals in the line direction X.

A plurality of the partition walls 3 are arrayed at certain intervals in the array direction Y so that the longitudinal direction of the partition walls 3 corresponds to the longitudinal direction of the electrodes 5 (the line direction X in the present embodiment) and are provided on the surface of the insulating film 6. Specifically, each partition wall 3 is provided at a position above the interval between the neighboring electrodes 5 as viewed from one side of the thickness direction Z. The partition wall 3 may be formed so as to be within the interval between the neighboring electrodes 5 or be formed to an area lying off the interval, as viewed from one side of the thickness direction Z.

The groove portion 8 is formed on the face 3a of each partition wall 3 along the longitudinal direction of the partition wall 3 (the line direction X in the present embodiment), the face 3a opposing another face near the substrate 2. The groove portion 8 is preferably formed so as to pass through the partition wall 3. In the present embodiment, the groove portion 8 passing through the partition wall 3 in the thickness direction Z is formed along the longitudinal direction of the partition wall 3.

The organic layer is formed at the portion 4 between partition walls. As described later, an organic EL element formed on the substrate 2 comprises one or a plurality of organic layers between a pair of electrodes and comprises at least one light-emitting layer as the organic layer. Between the pair of electrodes, an organic layer different from the light-emitting layer may be provided, and an inorganic layer may also be provided.

The light-emitting device comprises a plurality of the other electrodes formed so that their longitudinal direction corresponds to the array direction Y. In other words, the other electrodes are provided orthogonal to the electrodes 5 as viewed from one side of the thickness direction Z. The other electrodes are arranged at certain intervals in the line direction X so as to overlap with the through-holes 7 as viewed from one side of the thickness direction Z.

In the light-emitting device as described above, each of portions where the electrodes 5 and the other electrodes intersect as viewed from one side of the thickness direction Z functions as an organic EL element.

### [Structure of organic EL element]

Hereinafter, the structure of each organic EL element provided in the light-emitting device is described.

The organic EL element comprises a pair of electrodes (an anode and a cathode) and a light-emitting layer provided between the electrodes. Between the anode and the cathode, a plurality of organic layers or inorganic layers that are different from the light-emitting layer may be provided, and a plurality of the light-emitting layers may be provided.

Examples of the layer provided between the cathode and the light-emitting layer include an electron injection layer, an electron transport layer, a hole block layer and the like. When both of the electron injection layer and the electron transport layer are provided between the cathode and the light-emitting layer, a layer close to the cathode is called the electron injection layer, and a layer close to the light-emitting layer is called the electron transport layer.

The electron injection layer is a layer having a function to improve electron injection efficiency from the cathode. The electron transport layer is a layer having a function to improve electron injection from the cathode, the electron injection layer, or the electron transport layer closer to the cathode. The hole block layer is a layer having a function to block the transport of holes. When the electron injection layer and/or the electron transport layer has a function to block the transport of holes, the layer may also function as a hole block layer.

Examples of the layer provided between the anode and the light-emitting layer include a hole injection layer, a hole transport layer, an electron block layer, and the like. When both of the hole injection layer and the hole transport layer are provided, a layer close to the anode is called the hole injection layer, and a layer close to the light-emitting layer is called the hole transport layer.

The hole injection layer is a layer having a function to improve hole injection efficiency from the anode. The hole transport layer is a layer having a function to improve hole injection from the anode, the hole injection layer, or the hole transport layer closer to the anode. The electron block layer is a layer having a function to block the transport of electrons. When the hole injection layer and/or the hole transport layer has a function to block the transport of electrons, the layer may also function as an electron block layer.

The electron injection layer and the hole injection layer may be collectively called a charge injection layer, and the electron transport layer and the hole transport layer may be collectively called a charge transport layer.

Specific structures of the organic EL element are exemplified in the following a) to p).
a) anode/light-emitting layer/cathode
b) anode/hole injection layer/light-emitting layer/cathode
c) anode/hole injection layer/light-emitting layer/electron injection layer/cathode
e) anode/hole injection layer/light-emitting layer/electron transport layer/cathode
f) anode/hole injection layer/light-emitting layer/electron transport layer/electron injection layer/cathode d) anode/hole transport layer/light-emitting layer/cathode e) anode/hole transport layer/light-emitting layer/electron injection layer/cathode
f) anode/hole transport layer/light-emitting layer/electron transport layer/cathode
g) anode/hole transport layer/light-emitting layer/electron transport layer/electron injection layer/cathode
h) anode/hole injection layer/hole transport layer/light-emitting layer/cathode
i) anode/hole injection layer/hole transport layer/light-emitting layer/electron injection layer/cathode
j) anode/hole injection layer/hole transport layer/light-emitting layer/electron transport layer/cathode
k) anode/hole injection layer/hole transport layer/light-emitting layer/electron transport layer/electron injection layer/cathode
l) anode/light-emitting layer/electron injection layer/cathode
m) anode/light-emitting layer/electron transport layer/cathode
n) anode/light-emitting layer/electron transport layer/electron injection layer/cathode
   (Where the symbol "/" indicates that the layers crossing the symbol "/" are adjacently layered. The same shall apply hereinafter.)

### (Substrate)

The substrate is preferably a substrate that is not deformed while the organic El element is formed. For example, glass, plastic, macromolecular films, silicon substrates, and layered substrates in which the aforementioned substrates are layered are used. Plastic or macromolecular films that are subjected to water permeability reducing treatment may also be used for the substrate.

Each organic EL element may have a structure in which with reference to the substrate, an anode is arranged close to the substrate, and a cathode is arranged apart from the substrate, or a structure in which a cathode is arranged close to the substrate, and an anode is arranged apart from the substrate. In other words, in the present embodiment, the organic EL element may have a structure in which one of the electrodes is an anode, and the other of the electrodes is a cathode, or a structure in which one of the electrodes is a cathode, and the other of the electrodes is an anode.

Moreover, each organic EL element can have a bottom emission type element structure in which light is extracted from the side of the substrate, or a top emission type element structure in which light is extracted from the side opposite to the substrate. In the bottom emission type organic EL element, each layer positioning from the light-emitting layer to one of the electrodes is transparent. In the top emission type organic EL element, each layer positioning from the light-emitting layer to the other of the electrodes is transparent.

### (Anode)

When a transparent electrode is used for the anode, a thin film of metallic oxides, metallic sulfides, or metals that have high electric conductivity can be used, and an anode with high transparency is suitably used. Specifically, a thin film such as indium oxide, zinc oxide, tin oxide, indium tin oxide (abbreviated as ITO), indium zinc oxide (abbreviated as IZO), gold, platinum, silver, and copper is used and is appropriately selected depending on the type of the layer provided between the electrodes. Among them, ITO, IZO, and tin oxide are preferred for the anode.

An organic transparent conductive film such as polyaniline or a derivative thereof and polythiophene or a derivative thereof may also be used for the anode. A thin film made of a mixture containing at least one selected from the group consisting of materials used for the organic transparent conductive film, metallic oxides, metallic sulfides, metals, and carbon materials such as carbon nanotube may also be used for the anode.

For example, in the organic EL element having a structure in which light is extracted from the side of the cathode, the anode may be formed using a material that reflects light. Metals, metallic oxides, and metallic sulphides, all of which have a work function of 3.0 or more electron volts, are preferred for such a material.

The film thickness of the anode can be appropriately selected in consideration of light transparency and electric conductivity, and is, for example, 5 nanometers to 10 micrometers, is preferably 10 nanometers to 1 micrometer, and is more preferably 20 nanometers to 500 nanometers.

### (Hole injection layer)

For materials that constitute the hole injection layer, known materials can be appropriately used and are not particularly limited thereto. Examples of the materials include phenylamine series; starburst-type amine series; phthalocyanine series; hydrazone derivatives; carbazole derivatives; triazole derivatives; imidazole derivatives; oxadiazole derivatives having an amino group; oxides such as vanadium oxide, tantalum oxide, tungsten oxide, molybdenum oxide, ruthenium oxide, and aluminum oxide; amorphous carbon; polyaniline; polythiophene derivatives; and the like.

The thickness of the hole injection layer is appropriately set according to the intended design of the organic EL element and is preferably about 5 nanometers to 300 nanometers. When the thickness is less than 5 nanometers, the production tends to be difficult. On the other hand, when the thickness exceeds 300 nanometers, driving voltage and voltage applied to the hole injection layer tend to increase.

### (Hole transport layer)

The examples of materials that constitute the hole transport layer are not particularly limited, and include aromatic amine derivatives such as N,N'-diphenyl-N,N'-di(3-methylphenyl)4,4'-diaminobiphenyl (TPD) and 4,4'-bis[N-(1-naphtyl)-N-phenylamino]biphenyl (NPB), polyvinyl carbazole or derivatives thereof, polysilane or derivatives thereof, polysiloxane derivatives having an aromatic amine at the side chain or the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, poly(2,5-thienylene vinylene) or derivatives thereof, and the like.

Among them, preferred for the hole transport materials used for forming the hole transport layer are macromolecular hole transport materials such as polyvinyl carbazole or derivatives thereof, polysilane or derivatives thereof, polysiloxane derivatives having an aromatic amine compound group at the side chain or the main chain, polyaniline or derivatives thereof, polythiophene or derivatives thereof, polyarylamine or derivatives thereof, poly(p-phenylenevinylene) or derivatives thereof, and poly(2,5-thienylene vinylene) or derivatives thereof, and are more preferably polyvinyl carbazole or derivatives thereof, polysilane or derivatives thereof, and polysiloxane derivatives having an aromatic amine at the side chain or the main chain. When the hole transport materials are low molecular materials, the materials are preferably used by being dispersed in a macromolecular binder.

The thickness of the hole transport layer is not particularly limited, and is appropriately set according to the intended design of the organic EL element, and is preferably about 1 nanometer to 1000 nanometers. When the thickness is less than the lower limit, there are such tendencies that the production becomes difficult or that the effect of hole transport cannot be sufficiently obtained. On the other hand, when the thickness exceeds the upper limit, driving voltage and voltage applied to the hole transport layer tend to increase. Accordingly, the thickness of the hole transport layer is about 1 nanometer to 1000 nanometers as described above, is preferably 2 nanometers to 500 nanometers, and is more preferably 5 nanometers to 200 nanometers.

### (Light-emitting layer)

The light-emitting layer normally contains an organic substance (a low molecular compound and a macromolecular compound) that mainly emits fluorescence and/or phosphorescence, and may further contain a dopant material. Examples of light-emitting materials that constitute the light-emitting layer include the following pigment-based materials, metal complex-based materials, macromolecule-based materials, and dopant materials.

Examples of the pigment-based materials include cyclopendamine derivatives, tetraphenyl butadiene derivative compounds, triphenyl amine derivatives, oxadiazole derivatives, pyrazoloquinoline derivatives, distyrylbenzene derivatives, distyrylarylene derivatives, pyrrole derivatives, thiophene ring compounds, pyridine ring compounds, perynone derivatives, perylene derivatives, oligothiophene derivatives, trifumanyl amine derivatives, oxadiazole dimmers, pyrazoline dimmers, and the like.

Examples of the metal complex-based materials include metal complexes that emit light from the triplet excited state, which include iridium complexes and platinum complexes; metal complexes having as the central metal, Al, Zn, Be or the like, or a rare-earth metal such as Tb, Eu or Dy, and having as the ligand, a structure of oxadiazole, thiadiazole, phenylpyridine, phenylbenzimidazole or quinoline, or the like, which include alumiquinolinol complexes, benzoquinolinole beryllium complexes, benzoxazolyl zinc complexes, benzothiazole zinc complexes, azomethyl zinc complexes, porphyrin zinc complexes, europium complexes; and the like.

Examples of the macromolecule-based materials include polyparaphenylene vinylene derivatives, polythiophene derivatives, polyparaphenylene derivatives, polysilane derivatives, polyacetylene derivatives, polyfluorene derivatives, polyvinyl carbazole derivatives, materials in which the aforementioned pigments or metal complex-based light-emitting materials are subject to a treatment of making a macromolecule, and the like.

Among the light-emitting layer forming materials, examples of the materials that emit blue light include distyrylarylene derivatives or oxadiazole derivatives or polymers thereof, polyvinyl carbazole derivatives, polyparaphenylene derivatives, polyfluorene derivatives, and the like. Among them, macromolecular materials such as polyvinyl carbazole derivatives, polyparaphenylene derivatives, and polyfluorene derivatives are preferred.

Among the light-emitting layer forming materials, examples of the materials that emit green light include quinacridone derivatives or coumarin derivatives or polymers thereof, polyparaphenylene vinylene derivatives, polyfluorene derivatives, and the like. Among them, macromolecular materials such as polyparaphenylene vinylene derivatives and polyfluorene derivatives are preferred.

Among the light-emitting layer forming materials, examples of the materials that emit red light include coumarin derivatives or thiophene ring compounds or polymers thereof, polyparaphenylene vinylene derivatives, polythiophene derivatives polyfluorene derivatives, and the like. Among them, macromolecular materials such as polyparaphenylene vinylene derivatives, polythiophene derivatives and polyfluorene derivatives are preferred.

A dopant can be added to the light-emitting layer in order to improve the luminance efficiency, to change the luminescence wavelength, and the like. Examples of such a dopant include perylene derivatives, coumarin derivatives, rubrene derivatives, quinacridone derivatives, squarylium derivatives, porphyrin derivatives, styryl-based pigments, tetracene derivatives, pyrazolone derivatives, decacyclene, phenoxazon, and the like.

The thickness of the light-emitting layer is normally 2 nanometers to 200 nanometers.

### (Electron transport layer)

For materials that consist the electron transport layer, any know materials can be used. Examples of the materials include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or derivatives thereof, polyquinoline or derivatives thereof, polyquinoxaline or derivatives thereof, polyfluorene or derivatives thereof, and the like.

Among them, oxadiazole derivatives, benzoquinone or derivatives thereof, anthraquinone or derivatives thereof, metal complexes of 8-hydroxyquinoline or derivatives thereof, polyquinoline or derivatives thereof, polyquinoxaline or derivatives thereof, and polyfluorene or derivatives thereof are preferred, and 2-(4-biphenylyl)-5-(4-t-butylphenyl)-1,3,4-oxadiazole, benzoquinone, anthraquinone, tris(8-quinolinol)aluminum, and polyquinoline are more preferred.

### (Electron injection layer)

Examples of materials that constitute the electron injection layer include alkali metals and alkaline-earth metals; alloys that contain one or more kinds of the metals; oxides halides, and carbonates of these metals; and mixtures of these substances. The materials are selected as appropriate depending on the type of the light-emitting layer.

Examples of the alkali metals, and the oxides, halides and carbonates thereof include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, lithium carbonate, and the like.

Examples of the alkaline-earth metals, and the oxides, halides and carbonates thereof include magnesium, calcium, barium, strontium, magnesium oxide, magnesium fluoride, calcium oxide, calcium fluoride, calcium fluoride, barium oxide, barium fluoride, strontium oxide, strontium fluoride, magnesium carbonate, and the like.

Organometallic compounds doped with metals, metallic oxides or metallic salts, organometallic complex compounds, or a mixture thereof can also be used for the materials for the electron injection layer.

The electron injection layer may also have a layered structure in which two or more layers are stacked, and specifically includes a layered structure such as Li/Ca. The film thickness of the electron injection layer is preferably about 1 nanometer to 1 micrometer.

### (Cathode)

For materials for the cathode, materials that have small work function, facilitate electron injection into the light-emitting layer, and have high electric conductivity are preferred. In the organic EL element having a structure in which light is extracted from the side of the anode, materials having high reflectance of visible light are preferably used for the cathode. Specifically, the materials for the cathode include metals, metallic oxides, alloys, graphite, graphite interlayer compounds, and an inorganic semiconductor such as zinc oxide (ZnO).

As the metals, alkali metals, alkaline-earth metals, transition metals, the IIIb group metals or the like can be used. Specific examples of the metals include lithium, sodium, potassium, rubidium, cesium, beryllium, magnesium, calcium, strontium, barium, gold, silver, platinum, copper, manganese, titanium, cobalt, nickel, tungsten, tin, aluminum, scandium, vanadium, zinc, yttrium, indium, cerium, samarium, europium, terbium, ytterbium and the like.

Examples of the alloys include alloys containing at least one of the metals, and specifically include magnesium-silver alloys, magnesium-indium alloys, magnesium-aluminum alloys, indium-silver alloys, lithium-aluminum alloys, lithium-magnesium alloys, lithium-indium alloys, calcium-aluminum alloys, and the like.

In the organic EL element having a structure in which light is extracted from the side of the cathode, a transparent electrode is used for the cathode. Examples of materials for the transparent cathode include conductive oxides such as indium oxide, zinc oxide, tin oxide, ITO and IZO, and conductive organic substances such as polyaniline and derivatives thereof, and polythiophene and derivatives thereof.

The cathode may be a layered structure having two or more layers. The electron injection layer may be used as the cathode.

The film thickness of the cathode may be appropriately selected in consideration of electric conductivity and durability, and is, for example, 10 nanometers to 10 micrometers, is preferably 20 nanometers to 1 micrometer, and is more preferably 50 nanometers to 500 nanometers.

### (Upper sealing film)

Light-emitting materials for the light-emitting layer or the like are easily oxidized and are easily deteriorated by coming in contact with water. Therefore, the light-emitting device preferably further comprises the upper sealing film protecting the organic EL element. The upper sealing film is formed so as to cover each organic EL element from one of the thickness direction of the substrate 2. The upper sealing film comprises materials having high barrier properties against gas and liquid, and normally has a structure in which an inorganic layer and an organic layer are layered alternately.

Even when the organic EL element is sealed with the substrate and the upper sealing film, the permeability of a plastic substrate against gas and liquid is higher than that of a glass substrate. Therefore, when a plastic substrate is used for the substrate, a lower sealing film having high barrier properties against gas and liquid may be layered on the plastic substrate, and then an organic EL element may be layered on the lower sealing film in order to enhance sealing properties of the organic EL element. The lower sealing film is typically formed with the constitution and materials similar to those of the upper sealing film.

### [Method of manufacturing organic EL element]

Hereinafter, one embodiment of the method of manufacturing the organic EL element is described in detail below with reference to the accompanying drawings as appropriate.

### (Anode forming process)

A substrate made of any of the substrate materials as described above is provided. When a plastic substrate having high permeability against gas and liquid is used, a lower sealing film is formed on the substrate as needed.

Subsequently, an anode is patterned using any of the anode materials as described above on the prepared substrate. When a transparent anode is formed, the transparent electrode materials as described above such as ITO, IZO, tin oxide, zinc oxide, indium oxide and zinc-aluminum complex oxides are used. For example, the anode corresponding to the electrode 5 is formed by accumulating an ITO thin film having a uniform film thickness by a sputtering method on the substrate, and then patterning the ITO thin film in a stripe shape by photolithography.

### (Insulating film forming process)

The insulating film 6 is provided as needed. The insulating film 6 comprises, for example, organic substances such as photosensitive resin. A film of a photoresist layer is formed by applying a photoresist onto the substrate with the anode formed thereon. The certain area of the photoresist layer is exposed to light through a mask and then is developed to form a plurality of the through-holes 7. Thus, the insulating film 6 is formed.

For the photoresist, specifically, photosensitive resin of polyimide series, acrylic series, or novolac series can be used as appropriate. Among them, a polyimide series resin having high durability is suitably used. The application of the photoresist can be performed by a coating method using a spin coater, a bar coater, a roll coater, a die coater, a gravure coater, a slit coater or the like.

The insulating film 6 may comprise inorganic substances such as SiO₂ and SiN. For example, a thin film made of an inorganic insulating material having a thickness of 0.1 micrometer to 0.2 micrometer is formed on the substrate by a known method such as a plasma CVD method and a sputtering method. Subsequently, the through-holes 7 are formed at certain positions by photolithography. Thus, the insulating film 6 made of an inorganic substance is formed.

### (Partition wall forming process)

The partition wall 3 comprises an organic substance or an inorganic substance, and can be easily formed by photolithography. Therefore, the partition wall 3 preferably comprises photosensitive resin. A film of a photoresist layer is formed by applying a photoresist on the substrate with the insulating film 6 formed thereon. Subsequently, the certain area of the photoresist layer is exposed to light through a mask and is then developed to form a plurality of the partition walls 3. During this process, the groove portion 8 can be formed in the same process by simultaneously removing an area where the groove portion 8 is formed. When the insulating film 6 is not provided, the anode 4 is exposed at the portion 4 between partition walls.

For the photoresist, specifically, photosensitive resin of polyimide series, acrylic series, or novolac series can be used as appropriate. Among them, a polyimide series resin having high durability is suitably used. The application of the photoresist can be performed by a coating method using a spin coater, a bar coater, a roll coater, a die coater, a gravure coater, a slit coater or the like. The photoresist may comprise materials exhibiting light shielding properties in order to improve image quality of the organic EL element.

The main role of the partition wall 3 is to insulate between neighboring pixels separated by the partition wall 3 and to prevent color mixing between neighboring pixels separated by the partition wall 3. In contrast, the main role of the insulating film 6 is to insulate between pixels arranged along the longitudinal direction of the partition wall 3 (the line direction X), but the insulating film 6 does not have a function to prevent color mixing between neighboring pixels separated by the partition wall 3. Therefore, the height of the insulating film 6 in the thickness direction Z does not need to be as high as the height of the partition wall 3 in the thickness direction Z and is set to the extent that electrical insulation can be secured. The height of the partition wall 3 in the thickness direction Z is set to the extent that during application of an ink as described later, the applied ink does not overflow the partition wall. With reference to the basis, the height of the partition wall 3 in the thickness direction Z is set to preferably 0.1 or more micrometer and is more preferably 2 micrometers to 3 micrometers. The height of the insulating film 6 in the thickness direction Z is set to preferably 0.1 micrometer to 0.2 micrometer.

A width L1 of the partition wall 3 in the array direction Y is typically 5 micrometers to 50 micrometers, and is preferably 10 micrometers to 30 micrometers. A width L2 of the groove portion 8 in the array direction Y is set to a value allowing an ink flowing into the groove portion 8 to be accommodated in a process of supplying an ink described later, and is typically 1 micrometer to 30 micrometers, is preferably 5 micrometer to 30 micrometers, and is more preferably 5 micrometers to 20 micrometers.

The surface of the partition wall 3 preferably exhibits lyophobicity against an ink to be supplied, and preferably exhibits lyophobicity higher than that of one of the electrodes (anode). In the descriptions below, with reference to the anode 5, the case where the surface exhibits lyophilicity against an ink that are similar level to that of the anode 5 is described as exhibiting lyophilicity, and the case where the surface exhibits lyophobicity higher than that of the anode 5 is described as exhibiting lyophobicity. For example, when the surface of the partition wall 3 exhibits lyophilicity, an ink supplied to the portion 4 between partition walls spreads on the face 3a (hereinafter, also referred to as an upper face) of the partition wall 3 opposing another face near the substrate and easily flows into the neighboring portion 4 between partition walls. However, when the face of the partition wall 3 exhibits lyophobicity, the ink is repelled on the upper face of the partition wall 3, and therefore, the ink supplied to the portion 4 between partition walls can be prevented from flowing into the neighboring portion 4 between partition walls.

A method of imparting lyophobicity to the surface of the partition wall 3 includes surface treatment such as plasma treatment. Examples thereof include a method of modifying the surface by replacing the functional group of the organic material of the partition wall surface with fluorine. Specifically, CF₄ gas is converted to plasma using a vacuum plasma device to subject the partition wall surface to plasma treatment, and thus, lyophobicity can be imparted to the partition wall surface. In the plasma treatment using CF₄ gas, lyophobicity is imparted to members containing organic substances. Therefore, the anode 5 made of inorganic substances does not exhibits lyophobicity even after the plasma treatment. Therefore, the ink is easily applied onto the electrode. As described above, the ink supplied to the inside of the partition wall 3 can be prevented from overflowing the partition wall 3 and flowing into the neighboring portion between the partition walls by performing treatment for imparting lyophobicity to the partition wall 3.

When plasma treatment using CF₄ gas is performed, lyophobicity is imparted to the members made of organic substances, but are not imparted to the members made of inorganic substances. Therefore, when the insulating film 6 is made of inorganic substances, the insulating film 6 exhibits lyophilicity, and when the insulating film 6 is made of organic substances, the insulating film 6 exhibits lyophobicity. As described above, plasma treatment using CF₄ gas enables lyophobicity to be selectively imparted only to members made of organic substances and thus is preferable.

When the insulating film 6 is formed with a polyimide or the like as described above, both of the partition wall 3 and the insulating film 6 exhibit lyophobicity. For example, in an active matrix light-emitting device, a structure such as wiring is formed on the insulating film 6. The height of the structure in the thickness direction Z is typically 0.1 micrometer to 2 micrometers. When the structure is provided on the insulating film 6, and the insulating film 6 exhibits lyophilicity, an ink is supplied to the portion 4 between partition walls and is dried in a state where the ink is attracted to the structure. Therefore, an organic layer whose film thickness at the periphery of the through-hole 7 is larger than the film thickness at the center tends to be formed. However, even when the structure is formed on the insulating film 6, the insulating film 6 repels the ink by forming the insulating film 6 exhibiting lyophobicity. As a result, an organic layer having a uniform film thickness can be formed regardless of the structure.

In order to impart lyophobicity to the surface of the partition wall 3, lyophobic substances may be added to photosensitive materials used for forming the partition wall, an application liquid containing lyophobic components may be applied onto the surface of the partition wall 3 after the partition wall 3 is formed, or the lyophobic components may be vaporized to be accumulated on the partition wall surface. The surface of the partition wall 3 preferably exhibits lyophobicity against all ink used for forming each layer of the organic EL element.

For example, silicone based compounds or fluorine-containing compounds are used for the lyophobic substances added to the photosensitive materials. These lyophobic substances exhibit lyophobicity against an ink containing materials for a light-emitting layer, a hole transport layer or the like that is described later, and therefore can be suitably used.

### (Forming process of hole injection layer and hole transport layer)

After the formation of the partition wall, the hole injection layer, the hole transport layer, and the like that are described above are formed as needed. The method of forming films of the hole injection layer and the hole transport layer is not particularly limited, and examples of a method of forming a film using a low molecular material include a method of forming a film from a solution mixed with a macromolecular binder, and examples of a method of forming a film using a macromolecular material include a method of forming a film from the solution. In other words, an ink containing a material for the hole injection layer or the hole transport layer is applied by a application method and is further dried to form a hole injection layer or a hole transport layer.

For the macromolecular binder to be mixed as described above, a binder that does not extremely inhibit charge transportation is preferable, and a binder that does not have strong absorption of visible light is suitably used. Examples of the macromolecular binder include polycarbonate, polyacrylate, polymethyl acrylate, polymethyl methacrylate, polystyrene, polyvinyl chloride, polysiloxane, and the like.

A solvent for an ink that is used for forming a film from the solution is not particularly limited as long as the solvent can dissolve or disperse the material for the hole injection layer or the hole transport layer that is described above. Examples of the solvent include a chlorine-based solvent such as chloroform, methylene chloride and dichloroethane; an ether-based solvent such as tetrahydrofuran; an aromatic hydrocarbon-based solvent such as toluene and xylene; a ketone-based solvent such as acetone and methyl ethyl ketone; an ester-based solvent such as ethyl acetate, butyl acetate and ethyl cellosolve acetate; water; and the like.

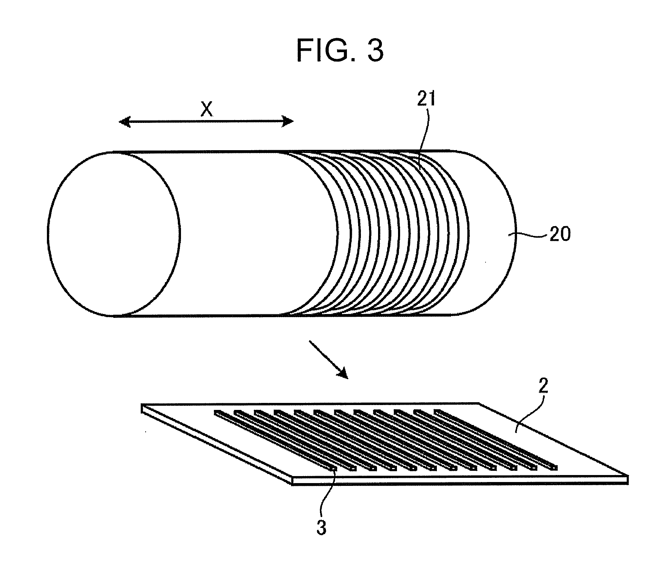

For the method of forming a film from the solution, a relief printing method is preferably used, and in the relief printing method, a flexo printing method is suitable. Fig. 3 is a schematic illustrating a process of forming a film of a hole injection layer or a hole transport layer from a solution. A relief printing plate 20 comprises a plurality of convex portions 21 that are arranged so as to correspond to the arrangement of concave portions 9 formed with the partition walls 3 and the substrate 2. Therefore, the convex portions 21 are arranged in substantially parallel to each other. The relief printing plate 20 comprises a plate cylinder and a printing plate that is wrapped around the surface of the plate cylinder to be fixed, and is arranged so that the axis center corresponds to the horizontal direction. The relief printing plate 20 is, for example, a flexo plate, and comprises flexible materials such as photosensitive materials (for example, an ultraviolet (UV) curable resin). A plurality of the convex portions 21 extend in the circumferential direction of the relief printing plate 20 to be provided.

The substrate 2 is arranged so that the longitudinal direction of the partition wall 3 corresponds to the application direction, and further, an ink containing the material for the hole injection layer or the hole transport layer is made to adhere to the convex portions 21 of the relief printing plate 20. Subsequently, while the relief printing plate 20 rotates and is pressed against the substrate 2, the substrate 2 is conveyed in a direction opposite to the printing direction. Thus, the ink adhered to the convex portions 21 is supplied to the concave portions 9. The ink supplied to the concave portions 9 is dried to remove the solvent, and thus, a hole injection layer or a hole transport layer can be formed. When the hole injection layer or the hole transport layer is an organic layer, the process as described above using the relief printing plate 20 corresponds to a process of forming an organic layer.

The ratio of the material for the hole injection layer or the hole transport layer in an ink is typically 0.1% by weight to 10% by weight, and is preferably 1% by weight to 5% by weight.

The hole injection layer and the hole transport layer may be formed by using a relief printing plate on which a plurality of the convex portions 21 are formed to extend in the axis direction of the relief printing plate and are provided at certain intervals in the circumferential direction.

### (Light-emitting layer forming process)

Next, the light-emitting layer is formed. When the hole injection layer and the hole transport layer are not provided, the light-emitting layer is formed so as to come in contact with the anode. The light-emitting layer is formed by supplying an ink containing a material for the light-emitting layer to the concave portions 9 using a relief printing plate similar to that as described above. Examples of the solvent used for forming a film from the solution include a single solvent such as toluene, xylene, acetone, anisole, methyl ethyl ketone, methyl isobutyl ketone, and cyclohexanone; and a mixed solvent thereof. Among them, an aromatic organic solvent such as toluene, xylene, and anisole is preferable because the solvent can favorably dissolve the light-emitting material. The ink can be supplied by a method similar to that as illustrated in Fig. 3. The ratio of the material for the light-emitting layer in an ink is typically 0.1% by weight to 10% by weight, and is preferably 1% by weight to 5% by weight. The light-emitting layer is an organic layer containing an organic substance, and the process of forming the light-emitting layer corresponds to a process of forming an organic layer.

In a light-emitting device for color display, light-emitting layers that emit red, green, and blue light (an R light-emitting layer, a G light-emitting layer, and a B light-emitting layer) need to be provided in the line direction X in order. Specifically, three rows of the light-emitting layers that are the R light-emitting layer, the G light-emitting layer, and the B light-emitting layer arrayed in the line direction X in this order are designated as a repeating unit, and the repeating unit is sequentially repeated in the line direction X to be arrayed. For example, when three kinds of ink containing light-emitting materials that emit red, green, and blue light, respectively (hereinafter, also referred to as an R ink, a G ink, and a B ink) are separately applied, the R ink is applied at intervals of two rows, the G ink is applied at intervals of two rows, and then the B ink is applied at intervals of two rows. In other words, different kinds of ink are supplied to the adjacent concave portions 9.

A surfactant, an antioxidant, a viscosity-adjusting agent, a UV absorber or the like may be added to the organic light-emitting ink as needed.

### (Electron injection layer and electron transport layer forming process)

After the formation of the light-emitting layer, the electron injection layer, the electron transport layer, and the like are formed as needed. The method of forming the electron transport layer is not particularly limited, and examples of the formation method using a low molecular electron transport material include a vacuum deposition method using the powder, and a method of forming a film from the solution or from the melted state. Examples of the formation method using a macromolecular electron transport material include a method of forming a film from the solution or from the melted state. When a film is formed from the solution or from the melted state, a macromolecular binder may also be used in combination. Examples of a method of forming a film of the electron transport layer from the solution include a film forming method similar to the method of forming a film of the hole transport layer from the solution as described above. When a film is formed from a solution, a relief printing method is preferably used as with the method of forming a light-emitting layer as described above.

The electron injection layer is formed by a vapor deposition method, a sputtering method, a printing method, or the like.

### (Cathode forming process)

The cathode is formed using any of the materials for the cathode as described above by a vacuum deposition method, a sputtering method, a CVD method, an ion plating method, a laser ablation method, a lamination method by which a metal thin film is press-bonded, or the like.

A process of providing the substrate 2 having a structure in which the partition walls 3 are arranged in substantially parallel to each other, and the groove portion 8 is formed on the face 3a of the partition wall 3 along the longitudinal direction of the partition wall 3, the face 3a opposing another face near the substrate, may be any of: (a) a process of directly providing the substrate 2 itself having such a structure; and (b) a process of providing the substrate 2 not having such a structure, processing the substrate 2 so as to have the structure, and ultimately, providing the substrate 2 having the structure.

In the process of forming an organic layer, the ink may overflow the concave portions 9 because the ratio of a material for an organic layer in an ink is low, and thus, the large amount of an ink as compared with the volume of the organic layer is supplied to the concave portions 9. However, even when the ink overflows the concave portions 9, the overflowed ink flows into the groove portion 8 formed in the partition walls 3. Therefore, the ink can be prevented from flowing into the neighboring concave portions 9. In such a manner, the ink can be prevented from flowing into the neighboring concave portions 9, and thus, an organic layer having a desired film thickness can be formed. The material for an organic layer means a material that becomes an organic layer after an ink is applied, and the ink comprises the material for an organic layer and a solvent dissolving the material for an organic layer.

Even when different types of ink are supplied to the neighboring concave portions 9, the ink can be prevented from flowing from the neighboring concave portions 9, and thus, the occurrence of color mixing can be prevented. Moreover, alignment between the relief printing plate 20 and the substrate 3 does not need to be performed in high-precision as in conventional arts because color mixing can be avoided by providing the groove portion 8. Therefore, the ink can be supplied efficiently.

Even when an ink having an amount larger than the volume of the portion 4 between partition walls is supplied to each of the concave portions 9, the partition wall 3 exhibits lyophobicity, and therefore, the ink is repelled at the upper face of the partition wall 3 so as to keep the ink at the portion 4 between partition walls. Accordingly, the ink can be prevented from flowing into the neighboring concave portions 9.

When the partition wall 3 exhibits lyophilicity, the ink supplied to the concave portions 9 is dried while being attracted to the partition wall 3, and as a result, the film thickness of the organic layer near the partition wall 3 becomes thick as compared with the film thickness at the center. However, in the present embodiment, the ink supplied to the concave portions 9 is dried while being repelled by the partition wall 3 exhibiting lyophobicity, and as a result, an organic layer having a uniform film thickness can be formed.

The light-emitting device of the present embodiment has a structure suitable for forming an organic layer using the relief printing plate 20 as described above because the groove portion 8 is formed in the partition wall 3.

A display device comprises the light-emitting device as described above and further comprises a driving device for driving the light-emitting device. For example, the driving device selectively applies voltage to one of the electrodes and the other of the electrodes and thus can selectively make a certain organic EL element emit light. As a result, certain image information can be displayed.

Although in the description as described above, the passive matrix light-emitting device is described, for example, an active matrix light-emitting device using a TFT substrate may be structured, or a display device using such an active matrix light-emitting device may also be structured.

### INDUSTRIAL APPLICABILITY

The method of manufacturing an organic electroluminescent element according to the present invention is useful for, for example, manufacture of a light-emitting device and a display device in which color mixing is prevented, and efficient manufacture of a light-emitting device and a display device by a relief printing method, and the like. The light-emitting device and the display device of the present invention are useful, for example, in that a color tone is excellent due to the prevention of color mixing and that the devices are efficiently manufactured by a relief printing method.

### EXPLANATIONS OF LETTERS OR NUMERALS

- 2: Substrate
- 3: Partition wall
- 3a: Face of partition wall opposing another face near substrate
- 4: Portion between partition walls
- 5: One of a pair of electrodes
- 6: Insulating film
- 7: Through-hole
- 8: Groove portion
- 9: Concave portion
- 20: Relief printing plate
- 21: Convex portion

## Claims

1. A method for manufacturing an organic electroluminescent element that comprises a pair of electrodes and an organic layer located between the electrodes, the method comprising:
providing a substrate on which a plurality of partition walls are arranged in substantially parallel to each other, and in which a groove portion is formed on a face of each of the partition walls along a longitudinal direction of the partition walls, the face opposing another face near the substrate; and
forming the organic layer by supplying an ink containing a material for the organic layer to concave portions formed with the partition walls and the substrate, using a relief printing plate in which a plurality of convex portions are arranged in substantially parallel to each other so as to correspond to the concave portions.

2. The method for manufacturing the organic electroluminescent element according to claim 1, wherein the groove portion is formed to pass through the partition walls.

3. A device for manufacturing the organic electroluminescent element according to claim 1, wherein a width of the groove portion in a direction perpendicular to a thickness direction of the substrate and the longitudinal direction is 5 micrometers to 30 micrometers.

4. The method for manufacturing the organic electroluminescent element according to claim 1, wherein a height of the partition wall is 0.1 or more micrometer.

5. A light-emitting device comprising:
a substrate;
a plurality of partition walls mounted on the substrate which are substantially parallel to each other; and
an organic electroluminescent element that comprises a pair of electrodes provided on the substrate and an organic layer located between the electrodes;
wherein the organic layer is formed between the partition walls, and
wherein a groove portion is formed on a face of each of the partition walls along a longitudinal direction of the partition walls, the face opposing another face near the substrate.

6. A display device comprising the light-emitting device according to claim 5.
